# EUROPEAN PATENT SPECIFICATION

(11) **EP 0 531 307 B1**
(45) Date of publication and mention of the grant of the patent: **03.08.1994**
(21) Application number: 91908426.9
(22) Date of filing: 19.04.1991
(51) Int. Cl.: G06K 19/073, G06K 7/08, G11C 16/06

(54) **UNIVERSAL IDENTIFICATION LABEL AND ASSOCIATED DETECTION SYSTEM**
UNIVERSALE IDENTIFIZIERUNGSETIKETT UND DAMIT VERBUNDENES DETEKTORSYSTEM
LABEL D'IDENTIFCATION UNIVERSEL ET SYSTEME DE DETECTION ASSOCIE

(30) Priority: 20.04.1990 NL 9000940
(43) Date of publication of application: 17.03.1993
(73) Proprietor: N.V. Nederlandsche Apparatenfabriek NEDAP, NL-7141 DE Groenlo (NL)
(72) Inventor: KIP, Harm, Jacob, NL-7132 CS Lichtenvoorde (NL)
(74) Representative: Smulders, Theodorus A.H.J. (NL)
(86) International application number: NL9100064
(87) International publication number: WO9116689

(56) References cited:
- EP-A- 0 213 534
- EP-A- 0 288 832
- WO-A-89/10618
- US-A- 4 780 855
- US-A- 4 796 235
- US-A- 4 877 945

## Description

The invention relates to a universal identification label for use in an electromagnetic detection system, and to an associated detection system.

Identification labels that operate according to the absorption principle as described in U.S. patent specification 3,299,424 (Vinding) often comprise a tuned coil in order to obtain a highest possible voltage across the coil through resonance phenomena. This is important, especially when the supply voltage for active logic circuits of the label must be drawn from the magnetic interrogation field, as is the case in the responder known from U.S. patent specification 4,196,418 (Nedap), because then within the permitted field strengths, the greatest possible distance can be bridged. It is true that a non-tuned coil provides a much smaller detection distance, but the frequency choice is free. Moreover, the relatively large bandwidth of such a system permits the use of non-sinusoidal signals. Use thereof is made in the apparatus described in German patent specification 3,149,789 (ADE), utilizing a diode in series with a short-circuit switch, so that only one phase of the a.c. voltage induced in the coil is used for modulation.

One object of the invention is to provide an identification label which provides both a great detection distance (which makes a tuned coil necessary, whereby the maximum data transmission speed is limited), and a high operative speed. A solution might be to make it possible for the tuning capacitor for the coil to be switched off. This is problematic owing to the high losses that can occur in an obvious type of electronic switch for that purpose. Therefore, according to a preferred embodiment of the invention, use is made of a series connection of two coils, at least one of which is tuned. In that case, the behaviour of the label is determined by whether the magnetic coupling occurs via the tuned coil or via the other coil, which may or may not be tuned. Adding a third coil, which is connected to its own rectifier, gives the possibility of generating a voltage with about 90° phase difference across these coils, either by externally providing two magnetic fields with the proper phase difference, or by internal phase rotation between the signals of the second coil and the third coil. Because of the overlapping phases, after rectification, a d.c. voltage is produced, in which the a.c. component is relatively small, so that a small smoothing capacitor will be sufficient. The provision of two magnetic fields which are phase-shifted 90° is known from the C2-card of the firm VALVO. For communication from the card reader to the card, in this known technique use is made of phase modulation of the two magnetic fields. A disadvantage is that the orientation of the card determines how the phase jump is transmitted. Moreover, a suitable phase detector is not simple. Owing to the large phase jump which occurs in a coil-capacitor circuit at the resonance frequency, it is virtually impossible to use tuned coils in the VALVO system. Therefore, the maximum detection distance is relatively small.

The invention provides a solution that is relatively easy to accomplish, in which the orientation-dependence of the label has disappeared, and which enables the use of tuned circuits, so that greater detection distances can be achieved.

To that effect, use is made of amplitude-modulation of two magnetic fields, in such a way that the occurrence of no or virtually no difference in the amplitudes of the magnetic fields or the corresponding electric signals represents a first logic level, and a predetermined difference in the amplitudes the other logic level. Because relative values are involved, the difference between the logic levels can remain small, so that little ripple is introduced on the supply voltage, while the detection still remains simple and reliable. This difference-modulation for the data transmission from reader to label can be used in combination with the known absorption-modulation for the communication from label to reader, provided that both coils are equally modulated. In this way, a full duplex connection is possible. The communication from label to reader thus occurs by means of common mode signals on the coils, while the communication from reader to label occurs by means of differential mode signals on the coils. By omission of the third coil, a subset is obtained, enabling half duplex communication.

Another object of the invention is thereby to provide a wireless interface for a microcontroller which is intended for communication in the manner described in the ISO 7816-3 standard "Identification cards, - Integrated circuit(s) with contacts-". For that purpose, the label can be coupled with a microcontroller or comprise a microcontroller and in that case is provided with an additional operative mode, namely the interface mode. This interface mode is switched on as soon as sufficient energy is available to feed the microcontroller and after an instruction to that effect has been received. In the interface mode, signals are generated in conformity with ISO standard 7816-3. The I/O pin is used bidirectionally and is coupled to the modulation completely transparently, i.e. that the modulation caused by the reader is supplied to this pin and that the logic level of this pin directly controls the modulation transistor and hence the field absorption. This feedback has as a result that during communication from reader to label, a positive feedback arises. This requires a proper dimensioning of the magnetic coupling between label and reader, in conjunction with the maximum achievable field absorption. When the label is not in the interface mode, all connections with the microcontroller are open, so that the microcontroller can then be used in conformity with ISO standard 7816. This means that compatibility with existing readers is maintained. The normal operative mode of an identification label is naturally to generate an identification code. In this mode the label is compatible with the function as described in U.S. patent specification 4,196,418 (Nedap). The capacity of the memory is different and the memory is of the EE-type, but a label according to the invention is read out in the same manner, i.e. serially and with the same data format as in a label according to U.S. patent specification 4,196,418. In identification labels that operate according to this principle, a resonance circuit with limited bandwidth is necessary because their application involves a great detection distance. This imposes limitations on the maximum data transmission speed. Often, however, only a part of all information from the memory is required. By making use of this fact, it is still possible to transmit the relevant information in a short time. This can be accomplished, inter alia, by selectively calling parts of the memory, as described in German Offenlegungsschrift 2,919,753 to Brown, Boveri & Cie AG. According to the technique known from German Offenlegungsschrift 2,919,753, access to the memory of the label, both for reading and for writing data, is controlled by means of opening codes. A disadvantage of this method is that the label must be capable of receiving and processing an opening code; this is hard to realize at a great distance with a label without a battery.

Accordingly, the invention provides a universal label as defined in claim 1. In essence the label has a memory structure in which it can be inputted which parts of the total label memory are to be read out. The order in which these parts are read out can also be programmed. To that effect, the memory is divided up into pages. There is added to the memory a table in which the numbers of the pages to be read out can be stored, and memory control means effect the reading of the page numbers as listed in the table. When the end of the table has been reached, the control means start this cycle again. Thus it is accomplished that already at a great distance between label and reader, specific information, for instance the identification code of the label, can be read out fast. By means of a password, it is also possible for the entire contents of the memory to be read out, if via the magnetic coupling sufficient energy is supplied for the purpose. If the distance between the label and the reader is smaller, also a higher field frequency can be used by means of the second coil, without going beyond the standardized limits. Reading out can then take place much faster. This could for instance be considered for applications involving verification, where many data are required. When changing the data of magnet cards or IC cards, the card is normally inserted in a read/write apparatus. The card is then retained until the writing process has been fully completed and checked. In an IC card, which can be read out according to a "hands-free" method, it is desirable, especially in view of the user's convenience, that programming can be done "hands free", i.e. without the card having to be inserted in a slot for that purpose. The energy the label requires for programming is much higher than the energy required for reading out. This means that the distance at which programming can be done is smaller than the read-out distance. An advantage of a small programming distance is that it is physically impossible to program more cards at the same time. According as the programming distance increases, there is a greater necessity to provide for protection, for instance by means of passwords, as is also described in German patent application DE-A-2919753 (BBC).

There are two problems, however, for which DE-A-2919753 does not provide any solution. The first problem is that when, for instance as a result of a communication error, incorrect data are written in the memory, the original information is lost. The lost data cannot be recovered in any manner. The data are not recoverable. By first putting the data to be changed in a buffer, these data can be recovered if anything has gone wrong. This solution is described in European patent application 0,282,926 in the name of Omron Tateisi Electronics Co. For a second problem, however, this reference does not provide a solution. When during recovery of data the energy supply of the label drops out, the information is lost anyhow. This can easily occur when the writing apparatus (programming apparatus) has no control over the availability of the card. This is for instance the case when there is no slot with a lock present.

The user may for instance remove the card before the writing process has been completed, and thereby incorrect information can be stored in the label or the card.

Because in most cases memories which have been built up with the relevant conventional techniques must be erased before writing, it is even possible that right after erasure the card is removed beyond the range of the writing apparatus, so that all information has disappeared from the card.

An obvious way of reducing this risk is to shorten the programming times by dividing the memory up into small units. In case of major errors, only little information will be mutilated or lost. A disadvantage of such small memory units is that the time that is necessary for erasing and writing a lot of information may run up considerably, which also increases the chances of the label being removed during this process. An object of the invention is to provide a memory structure such that premature removal of the card beyond the range of the writing apparatus does not result in the mutilation or loss of information. Nor will communication errors and other errors cause any irreparable data loss. To that effect, according to the invention, the memory is divided up into pages which can be erased and written by page. By effecting erasure by page, a number of words are erased simultaneously, and a substantial saving of time can be accomplished. Further, for erasing and writing new information, an additional buffer memory page has been added. All new information is first written in the buffer memory page. The buffer page is not made valid until it has been established that no errors have occurred in the process, and, if so desired, it has been checked whether the information has been written in sufficiently "hard" manner. Then another page is designated as the new buffer page. Thus it is accomplished that the information in the card can be in one of two conditions only: either the old information remains valid or the new information is valid. The undefined condition has disappeared. By changing the pages round again, the old information can be recovered even after the buffer page has been made valid.

For indicating which memory pages are valid and hence can be read out, the invention comprises two tables, of which at any time one is valid. The valid table lists the read out sequence of the memory pages, that is, of all valid pages. Further, this table indicates what page functions as a buffer. By adapting the second table after new information has been written in the buffer page, the way is prepared so that the new information can also be read. Only when the new information after reading has been finally approved, does switching from the old to the new table take place. This switching operation enables subsequent reading out according to the new table.

In principle, choosing between the two tables can still go wrong, but because switching requires only one bit, the chances of anything going wrong here are small. By making the switching bit redundant, this risk can be further reduced. Moreover, all old information is still valid; no part thereof has been overwritten or erased.

Because the writing of new data is only possible in locations that contain no valid data, that is, the buffer page and the non-valid table, not even a communication error during programming can cause any irreparable loss of information. By determining the reading sequence of the memory pages by means of a table, it is also accomplished that the readout sequence of the data is programmable and that the number of pages that is read out is programmable.

## Claims

1. A universal label for an electromagnetic identification system, said label having a receiver circuit comprising at least one coil, and a memory of the EEprom type wherein a number of pages for data storage have been defined, characterized in that in the memory an additional buffer page is defined, as well as two tables, of which at any time only one is valid, the valid table containing information about the valid pages that can be read out; that there is provided an additional memory element which indicates which of the two tables is valid; that at any time new data can be written only in the invalid table and in the additional buffer page, whose page number is indicated in the valid table, access to the designated buffer page being obtained via the valid table, and that means are provided for changing round the validity of the two tables.

2. A universal label according to claim 1, characterized in that the valid table is programmable and contains information about the sequence and the number of the memory pages that can be read out.

3. A universal label according to claim 1 or 2, characterized in that the receiver circuit of the label comprises at least two coils, one of which together with a capacitor forms a resonance circuit, said resonance circuit being connected in series with at least one second coil of the at least two coils wherein said at least one second coil may or may not be tuned, so that different working frequencies can be used for one and the same label.

4. A universal label according to claim 1, 2, or 3, used as an interface for a microcontroller, characterized in that the I/O pin of the microcontroller is transparently coupled with the receiver circuit.

5. A universal label according to any one of claims 1, 2, 3, or 4, characterized by at least one additional coil in the receiver circuit and by detection means for detecting a difference in amplitude of a signal induced in said at least one coil and said at least one additional coil and by modulation means for simultaneous modulation of said at least one coil and said at least one additional coil.

6. An electromagnetic detection system comprising at least one transmitter/receiver and at least one identification label according to any one of claims 1-5.

7. An electromagnetic detection system according to claim 6, characterized by means for simultaneously generating two interrogation fields shifted in phase relative to each other.

## Patentansprüche

1. Universelle Marke für ein elektromagnetisches Identifizierungssystem, die eine Empfängerschaltung mit wenigstens einer Spule und einen Speicher vom EEPROM-Typ aufweist, in dem eine Anzahl von Seiten für die Datenspeicherung definiert sind, dadurch gekennzeichnet, daß in dem Speicher eine zusätzliche Pufferseite sowie zwei Tabellen definiert sind, von denen zu jeder Zeit nur eine gültig ist, wobei die gültige Tabelle Informationen über die gültigen Seiten enthält, die auslesbar sind; daß ein zusätzliches Speicherelement vorgesehen ist, das angibt welche der beiden Tabellen gültig ist; daß zu jeder Zeit neue Daten nur in die ungültige Tabelle und in die zusätzliche Pufferseite, deren Seitenzahl in der gültigen Tabelle angegeben ist, eingeschrieben werden können, wobei der Zugriff auf die angegebene Pufferseite über die gültige Tabelle erfolgt, und daß eine Einrichtung zum Wechseln der Gültigkeitszustände der beiden Tabellen vorgesehen ist.

2. Universelle Marke nach Anspruch 1, dadurch gekennzeichnet, daß die gültige Tabelle programmierbar ist und Informationen über die Abfolge und die Zahl der Speicherseiten, die auslesbar sind, enthält.

3. Universelle Marke nach Anspruch 1 oder 2, dadurch gekennzeichnet, daß die Empfängerschaltung wenigstens zwei Spulen aufweist, von denen eine zusammen mit einem Kondensator eine Resonanzschaltung bildet, die in Reihe mit wenigstens einer zweiten Spule der wenigstens zwei Spulen geschaltet ist, wobei die wenigstens eine zweite Spule abgestimmt oder nicht abgestimmt sein kann, so daß für die selbe Marke unterschiedliche Arbeitsfrequenzen verwendet werden können.

4. Universelle Marke nach Anspruch 1, 2 oder 3, als Interface für eine Mikrosteuerungsvorrichtung, dadurch gekennzeichnet, daß der E/A-Pin der Mikrosteuerungsvorrichtung transparent mit der Empfängerschaltung verbunden ist.

5. Universelle Marke nach einem der Ansprüche 1, 2, 3 oder 4, gekennzeichnet durch wenigstens eine weitere Spule in der Empfängerschaltung und durch eine Erkennungseinrichtung zum Erkennen einer Amplitudendifferenz eines in die wenigstens eine und die wenigstens eine zusätzliche Spule induzierten Signals und durch eine Modulationseinrichtung zum gleichzeitigen Modulieren der wenigstens einen Spule und der wenigstens einen zusätzlichen Spule.

6. Elektromagnetisches Erkennungssystem mit wenigstens einem Sendeempfänger und wenigstens einer Identifizierungsmarke nach einem der Ansprüche 1-5.

7. Elektromagnetisches Erkennungssystem nach Anspruch 6, gekennzeichnet durch eine Einrichtung zum gleichzeitigen Erzeugen zweier in bezug zueinander phasenverschobener Abfragefelder.

## Revendications

1. Etiquette universelle pour un système d'identification électro-magnétique, ladite étiquette comportant un circuit récepteur comprenant au moins une bobine, une mémoire du type mémoire morte effaçable et programmable électriquement dans laquelle un certain nombre de pages pour mémorisation de données ont été définies, caractérisé en ce que dans la mémoire une page tampon supplémentaire est définie, de même que deux tables, dont une seulement à un instant donné est valide, la table valide contenant des informations concernant les pages valides qui peuvent être extraites, en ce qu'il est prévu un élément mémoire supplémentaire qui indique laquelle des deux tables est valide, en ce que à tout moment des nouvelles données peuvent être écrites seulement dans la table non valide et dans la page tampon supplémentaire, dont le numéro de page est indiqué dans la table valide, l'accès à la page tampon désignée étant obtenu par l'intermédiaire de la table valide et en ce que des moyens sont prévus pour commuter la validité des deux tables.

2. Etiquette universelle selon la revendication 1, caractérisée en ce que la table valide est programmable et contient des informations concernant la séquence et le nombre de pages mémoires qui peuvent être extraites.

3. Etiquette universelle selon la revendication 1 ou 2, caractérisée en ce que le circuit récepteur de l'étiquette comprend au moins deux bobines, dont l'une forme avec un condensateur, un circuit résonant , ledit circuit résonant étant connecté en série à au moins une seconde bobine d'au moins les deux bobines, dans lequel ladite au moins seconde bobine peut être ou ne pas être accordée, de sorte que des fréquences de travail différentes puissent être utilisées pour une seule et même étiquette.

4. Etiquette universelle selon la revendication 1, 2 ou 3, utilisée comme une interface pour un micro-contrôleur, caractérisée en ce que la broche d'entrée/sortie du micro-contrôleur est couplée de manière transparente au circuit récepteur.

5. Etiquette universelle selon l'une quelconque des revendications 1, 2, 3 ou 4, caractérisée par au moins une bobine supplémentaire dans le circuit récepteur et par un moyen de détection pour détecter une différence d'amplitude d'un signal induit dans ladite au moins une bobine et dans ladite au moins une bobine supplémentaire et par un moyen de modulation pour moduler simultanément ladite au moins une bobine et ladite au moins une bobine supplémentaire.

6. Système de détection électro-magnétique comprenant au moins un émetteur/récepteur et au moins une étiquette d'identification selon l'une quelconque des revendications 1 à 5.

7. Système de détection électro-magnétique selon la revendication 6, caractérisé par un moyen pour produire simultanément deux champs d'interrogation déphasés l'un par rapport à l'autre.
